# EUROPÄISCHE PATENTANMELDUNG

(11) **EP 0 525 364 A1**
(43) Veröffentlichungstag der Anmeldung: **03.02.1993**
(21) Anmeldenummer: 92110225.7
(22) Anmeldetag: 17.06.1992
(51) Int. Cl.: H05K 13/00

(54) **Vorrichtung zum Speichern und Transportieren von oberflächenempfindlichen Leiterplatten**

(30) Priorität: 01.08.1991 DE 4125496
(71) Anmelder: Löhr & Herrmann GmbH, D-75242 Neuhausen/E. (DE)
(72) Erfinder: Löhr, Hans-Günter, Dr.-Ing., W-7135 Wiernsheim (DE); Herrmann, Gunter, Dr.-Ing., W-7260 Calw (DE); Mozzi, Josef, W-7531 Neuhausen-Hamberg (DE)
(74) Vertreter: Twelmeier, Ulrich, Dipl.Phys.

(57) **Zusammenfassung**

Die Erfindung bezieht sich auf eine Vorrichtung zum Speichern und Transportieren von oberflächenempfindlichen Leiterplatten in Form eines Magazins, bestehend aus einem Grundkörper mit Auflagefläche

- Stapeltisch - oder Aufstellflache mit schwach schräggestelltem Rückenteil - Stapelwinkel - zum Auflegen oder -stellen von Leiterplatten als Stapel, wobei nach Patent ....... (P 41 22 272.5) beidseits der Auflage- bzw. Stellfläche in Richtung der Stapelung langlochförmige Bügel angeordnet sind, welche Zwischenlagen für die Leiterplatten von der hängenden Ruhestellung in die liegende oder hängende Arbeitsstellung mit zwischenliegenden Leiterplatten verschieb- und umklappbar geführt aufnehmen, wobei parallel hierzu zwei zueiander symmetrisch angebaute, synchron verlaufende Riemenantriebe mit entsprechend langlochförmiger Bahn angebracht sind, an deren Riemen jeweils Greifer so angebracht sind, daß diese mit dem Riemen umlaufen, wobei die Greifer aus zwei einzeln ausschwenkbaren Greiferbacken bestehen, die durch stationäre Antriebe betätigbar sind und in denen vorzugsweise Sensoren zum selbsttätigen Positionieren der Greifer an einer sich in beliebiger Lage befindlichen Zwischenlage eingebaut sind.

## Beschreibung

Die Erfindung betrifft eine Vorrichtung zum Speichern und Transportieren von oberflächenempfindlichen Leiterplatten in Form eines Magazins, bestehend aus einem Grundkörper mit Auflagefläche - Stapeltisch - oder Aufstellfläche mit schwach schräggestelltem Rückenteil - Stapelwinkel - zum Auflegen oder -stellen von Leiterplatten als Stapel und zwar als Weiterbildung nach dem Patent ....... (EPA ), wonach beidseits der Auflage- bzw. Stellfläche in Richtung der Stapelung langlochförmige Bügel angebracht sind, welche Zwischenlagen für die Leiterplatten

von der hängenden Ruhestellung in die liegende oder hängende Arbeitsstellung mit zwischenliegenden Leiterplatten verschieb- und umklappbar geführt aufnehmen.

Hierbei sind die Zwischenlagen am Magazin befestigt und bleiben mit diesem ständig verbunden, wobei das Belasten der Magazine mit Leiterplatten und das Umklappen der Zwischenlagen wechselbar erfolgt, so daß zwischen zwei Leiterplatten jeweils eine Zwischenlage zu liegen kommt. Das Entladen der Magazine geschieht sinngemäß umgekehrt.

Aufgabe der vorliegenden Erfindung als Weiterbildung ist es, eine automatisch arbeitende Vorrichtung zu schaffen, mit der die Zwischenlagen selbsttätig umgeklapptwerden können anstelle von Hand, was in Bezug auf die Kosten der Handhabung und Sauberkeit der Oberflächen von Vorteil ist. Das automatische Be- und Entladen der Leiterplatten ohne Zwischenlage ist demgegenüber bereits üblich.

Zur Lösung dieser Aufgabe kennzeichnet sich die Vorrichtung der Erfindung nach dem Oberbegriff des Anspruchs 1 dadurch, daß parallel zum langlochförmigen Bügel zur verschieb- und umlegbaren Aufnahmen von Zwischenlagen zwei zueinander symmetrisch angebaute, synchron verlaufende Riementriebe mit entsprechend langlochförmiger Bahn angebracht sind, an deren Riemen jeweils Greifer so vorgesehen sind, daß diese mit dem Riemen umlaufen, wobei die Greifer aus zwei einzeln ausschwenkbaren Greiferbacken bestehen, die durch stationäre Antriebe betätigbar sind und in den vorzugsweise Sensoren zum selbsttätigen Positionieren der Greifer an einer sich in beliebiger Lage befindlichen Zwischenlage eingebaut sind.

Somit besteht die Vorrichtung aus zwei symmetrisch zueinander auf dem Grundkörper eines Leiterplattenstaplers aufgebauten Hälften mit jeweils einem Gestell, welche an ihrem einen Ende eines flexiblen Riemenantrieb besitzen, an dessen Riemen ein Greifer fest angebracht ist, so daß dieser mit dem Riemen umläuft. Die Bahn des Riemens ist langlochförmig ausgebildet und entspricht der Form der am Magazin angebrachten Bügel, welche die Führung der zwischenlagen während des Umklappens übernehmen.

Die Greifer zeigen mit ihren Greiferbacken in Richtung der Zwischenlage und sind einzeln ausschwenkbar, um Kollisionen mit den Zwischenlagen während des Abholvorganges bzw. beim Wegfahren der Greifer von der Aufnahme- oder Agabestelle der Zwischenlagen zu vermeiden. Dieses Ausschwenken der Greifer geschieht mittels geeigneter Antriebe, z.B. Pneumatikzylindern, die fest an der Aufnahme- bzw. Abgabestelle der Zwischenlagen befestigt sind. Solange die Greifer in Bewegung sind, d.h. während des Umklappens der Zwischenlagen, sind sie eingeschwenkt und werden mittels Federn in dieser Lage gesichert.

Da die Zwischenlagen je nach Anzahl der bereits eingespeicherten Leiterplatten an variablen Stellen im Magazin abgeholt bzw. abgegeben werden müssen, besitzt die Vorrichtung an den Greifern zwei oder mehrere Sensoren, die die Annäherung der Greifer an die zuvorderst liegende Zwischenlage erkennen und ein Signal aussenden, das zum Abschalten des Riemenantriebs und damit auch der Greiferbewegung verwendet wird. Bei geeigneter Anzahl der Sensoren und Antriebe läßt sich eine Abschaltposition für die Greifer erzielen, die nur um Bruchteile von Millimetern von der zufälligen Position der zuvorderst liegenden Zwischenlage abweicht.

Wenn diese Position erreicht ist, schwenken die Greifer ein und greifen die Zwischenlage an ihrem als Trägerleiste ausgebildeten Rand von zwei Seiten form- oder kraftschlüssig. Dazu ist ein Spalt zwischen den beiden Greiferbacken vorhanden, der gewährleistet, daß beim Einschwenken der Greiferzangen der Greiferbacken in den Spalt paßt. Ferner ist durch Ausbildung der Trägerleisten mit versetzten Wulsten oder Abstandshaltern dafür Sorge zu tragen, daß keine der Greiferzangen mit einer Trägerleiste der nachfolgenden Zwischenlagen beim Einschwenken kollidiert.

Eine bevorzugte Ausführung einer Vorrichtung gemäß der Erfindung als Weiterbildung nach dem Hauptpatent ist beispielsweise in der Zeichnung dargestellt und nachfolgend beschrieben und zwar zeigen:
Figur 1 eine perspektivische Ansicht der ersten Vorrichtung nach dem Hauptpatent mit einer Zwischenlage,
Figur 2 eine schematische Seitenansicht des leeren Magazins mit Zwischenlagen in Vorratsstellung hierzu,
Figur 3 eine schematische Seitenansicht des Umklappvorgangs einer Zwischenlage beim Befüllen des Magazins und
Figur 4 eine schematische Seitenansicht des teilweise beladenen Magazins mit Zwischenlagen hierzu,
Figur 5 eine perspektivische Ansicht einer Zwischenlage hierzu,
Figur 6 eine Seitenansicht der Vorrichtung nach der Weiterbildung und
Figur 7 eine Vorderansicht zu der Weiterbildung sowie
Figur 8 eine Einzelheit beim Greifen einer Zwischenlage.

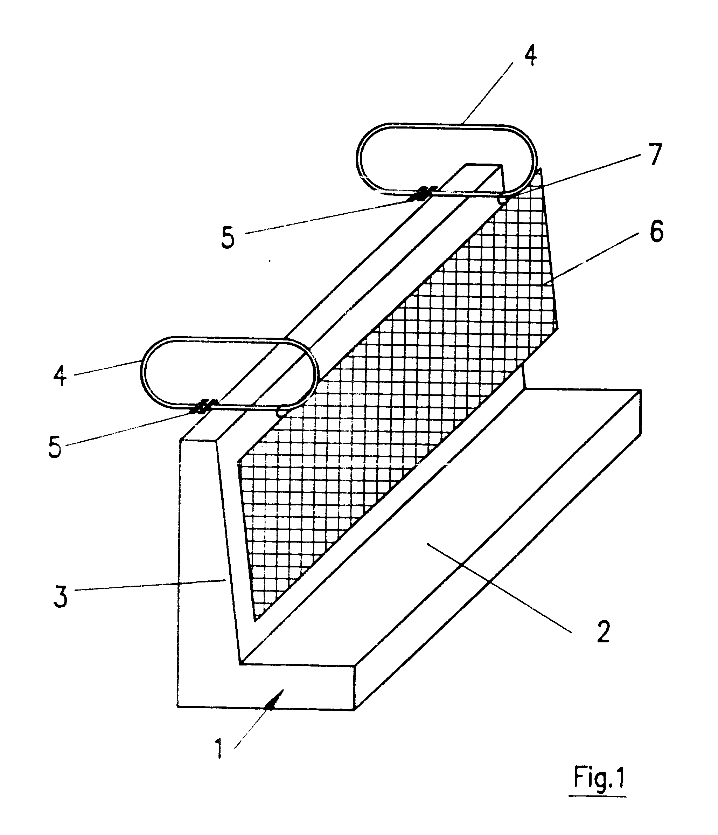

Bei der Ausführung nach Fig. 1 besitzt der Grundkörper 1 des Magazins als Winkelanordnung, wie ersichtlich, eine Aufstellfläche 2 und Rückenteil 3 mit schwacher Schrägung. Hier sind auf dem Rückenteil 3 beidseits langlochförmige Bügel 4 aus Rundmaterial befestigt, die jeweils einen Verschluß 5 zum Einbringen der Zwischenlagen 6 mit Ösen 7 aufweisen. Die langlochförmigen Bügel 4 sind liegend angebracht in Richtung der Stapelung. Bei Tischanordnung mit liegender Auflagefläche für die Stapelung nach der weiteren Ausführung beim Hauptpatent sind die Bügel entspr. stehend angeordnet.

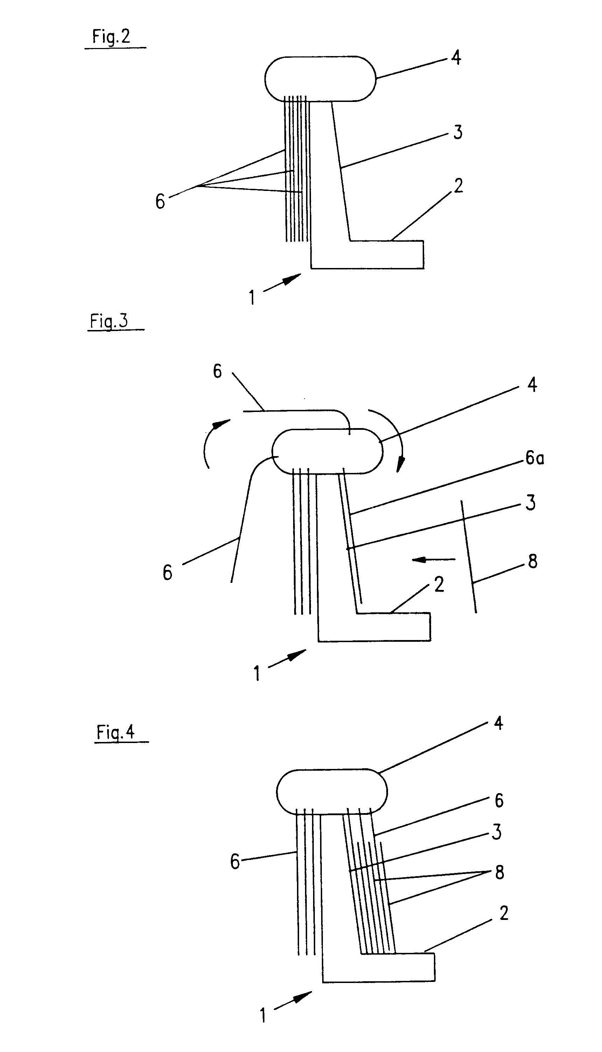

Den Ausgangszustand des leeren Magazins mit mehreren Zwischenlagen 6 zeigt Fig. 2. Die Zwischenlagen 6 hängen hier hintereinander aufgereiht auf der dem Rückenteil 3 abgewandten Seite. Demgegenüber zeigt die Fig. 3 den Umklappvorgang für die Zwischenlagen 6, ferner eine bereits umgeklappte Zwischenlage 6a und schematisch das Einlegen einer Leiterplatte 8 in das Magazin. Nach Fig. 4 ist erkennbar, wie die Zwischenlagen 6 im Wechsel mit den Leiterplatten 8 auf der Aufstellfläche 2 gespeichert werden und nicht benötigte Zwischenlagen auf der abgewandten Seite des Magazin-Rückenteils 3 hängend auf der Vorratsseite verbleiben.

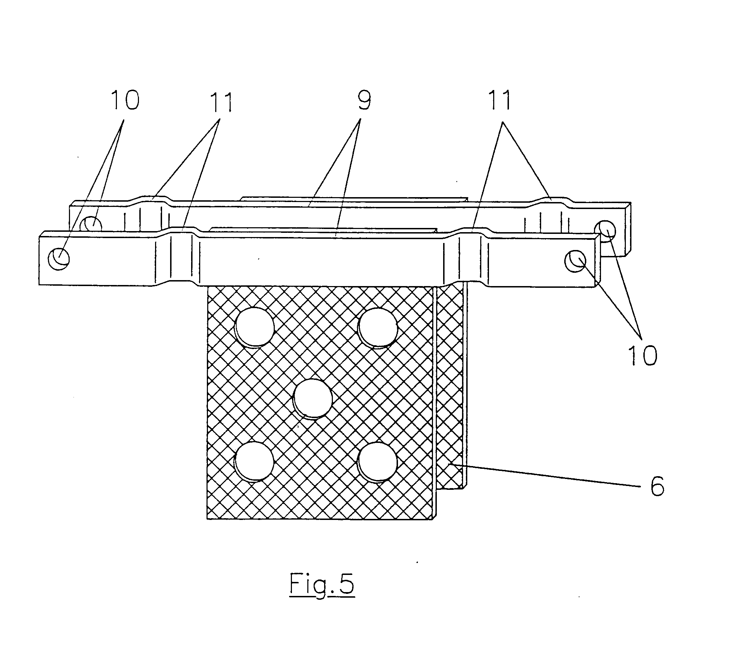

Im übrigen bestehen die Zwischenlagen 6, z.B. als Geflecht oder Gitter mit Öffnungen, entspr. Fig. 5 aus flexiblem Material mit weicher Oberfläche, insbes. teflonbeschichteten Glasfasergeweben. Soweit besondere Trägerleisten 9 mit Lochungen 10 vorhanden sind, können diese Abstandswulste 11 zu deren Griff aufweisen. Schließlich kann die Überführung der Zwischenlagen 6 von der Vorratsstellung in die Arbeitsstellung jeweils als Zwischenlage 6 für die Leiterplatten 8 bei deren Stapelung auf der Auflage- oder der Aufstellfläche mittels motorgetriebener, parallelgeführter Mitnahmeklemmen zu betätigen sein, wie dies bei der Weiterbildung im folgenden beschrieben ist.

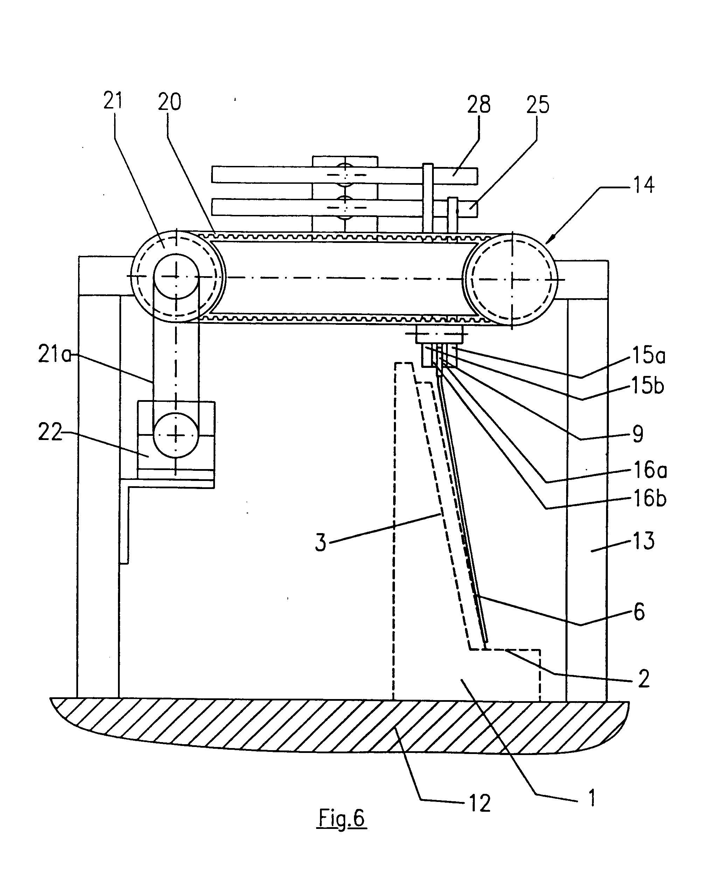

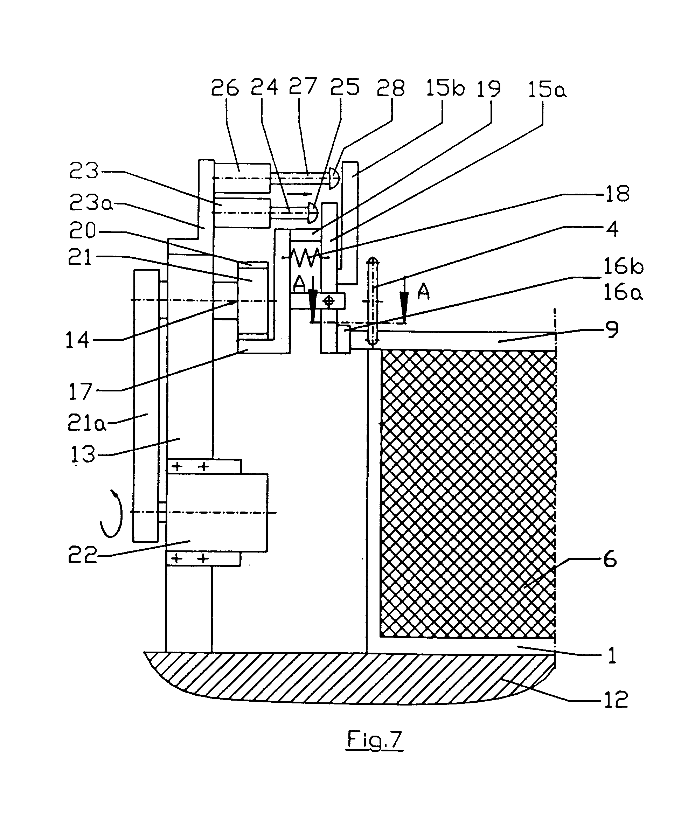

Eine Weiterbildung nach dem Zusatz zeigt Fig. 6 in Seitenansicht und Fig. 7 in Vorderansicht. Aus Fig. 6 ist der Grundkörper 1 mit Aufstellfläche 2 und Rückenteil 3 eines Magazins ersichtlich, dem ein Grundgestell 12 zugeordnet ist. An diesem (12) ist ein aus zwei symmetrischen Hälften bestehendes Gestell 13 aufgebaut, an dessen oberen Ende der langlochförmig ausgebildete Riementrieb 14 angebracht ist. Ferner sind zwei Greifer 15a und 15b dargestellt, deren Greiferbacken 16a und 16b im Eingriff mit der Trägerleiste 9 einer Zwischenlage 6 sind.

In Fig. 7 sind die langlochförmigen Bügel 4 dieser Vorrichtung erkennbar, die am Magazinkörper 1 befestigt sind und die parallel zum Riemenantrieb 14 liegen. Die Greifer 15a und 15b sind an einem Haltewinkel 17 schwenkbar befestigt. Die Feder 18 zieht die Greifer gegen den Anschlag 19 in dieser Lage sind die Greiferbacken eingeschwenkt. Der Haltewinkel 17 ist fest mit dem umlaufenden Riemen 20 verbunden, der über die Riementriebe 21 und den Riementrieb 21 vom Motor 22 angetrieben wird.

In Fig. 7 ist ferner erkennbar der z.B. als Zylinder ausgeführte Antrieb 23, der mittels eines Winkels 23a am Gestell 13 befestigt ist. Am Ende des Kolben 24 ist eine Druckleiste 25 angebracht, die beim Vorfahren des Kolben 24 den Greifer 15a ausschwenkt. Ferner ist ein gleichartiger Antrieb 26 oberhalb des Antriebs 23 angebaut, der über seinen Kolben 27 die Druckleiste 28 nach vorne schiebt und damit den Greifer 15b verschwenkt. Durch Wahl der geeigneten Länge der Druckleisten 25 und 28 können beide Greifer 15a und 15b an jeder möglichen Aufnahme- bzw. Abgabestelle der Zwischenlagen 6 ausgeschwenkt werden.

Um das Vereinzeln der Zwischenlagen 6 zu ermöglichen, besitzen diese eine Trägerleiste 9 mit Abstandswulsten 11, wie Fig. 5 zeigt. Diese Wulste 11 sind an aufeinanderfolgenden Zwischenlagen seitlich versetzt, so daß auch beim Aufschließen der Zwischenlagen stets ein bestimmter Spalt zwischen den Enden der Trägerleisten 9 erhalten bleibt, in die die Greiferbacken 16a bzw. 16b ohne Kollision einschwenken können.

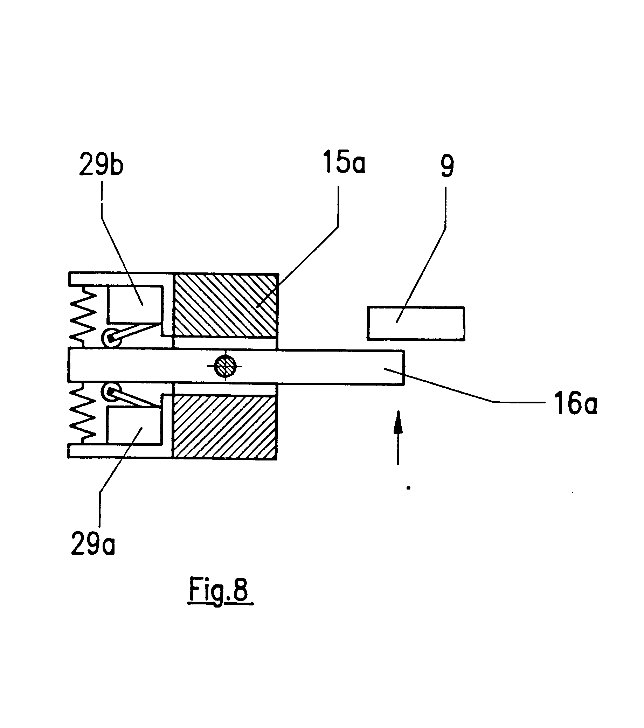

Zur Positionierung der Greifer 15a und 15b beim Anfahren der Trägerleisten 9 sind die Greiferbacken 16a drehbar aufgehängt. Beim Auftreffen auf die Trägerleisten 9 wird, wie aus dem Schnitt AA in Fig. 8 ersichtlich, die Greiferbacke 16a ausgelenkt und betätigt einen z.B. als Mikroschalter ausgeführten Sensor 29a oder, bei umgekehrter Verfahrrichtung, den Sensor 29b, worauf der Riemenantrieb abgeschaltet wird.

Der Vereinzelungs- und Umklappvorgang der Zwischenlagen 6 läuft nunmehr, wie schematisch in Fig. 3 gezeigt, wie folgt ab:
Ausgangszustand sind die sich ohne Zwischenlage im Uhrzeigersinn vom Riemenantrieb 14 mitbewegten Greifer 15a und 15b. Beim Einlaufen in den unteren, horizontalen Teil des Riemenantriebs 14, vor Erreichen der Endposition, wird der Greifer 15b ausgeschwenkt, wozu der Antrieb 26 (Fig. 7) verwendet wird. Beim Auftreffen der zum Greifer 15a gehörenden Greiferbacke 16a wird der Sensor 29a (Fig. 8) betätigt, der den Riemenantrieb 19 anschaltet. Anschließend wird der Greifer 15b wieder zurükgeschwenkt, so daß die zur Zwischenlage 6 gehörende Trägerleiste 9 zwischen den beiden Greiferbacken 16a und 16b eingeklemmt wird. Die Greifer 15a und 15b werden anschließend vom Rimenantrieb 14 im Gegenuhrzeigersinn zur Endposition gebracht (siehe Fig. 3).

Sobald die Greiferbacke des Greifers 15a auf eine bereits umgeklappte Trägerleiste 9 trifft, wird diese ausgelenkt, der Sensor 29b betätigt, worauf sich der Riemenantrieb 14 abschaltet. Mit den Antrieben 23 und 26 (Fig. 7) werden beide Greifer 15a und 15b ausgeschwenkt und bleiben so lange ausgeschwenkt, bis beide Greifer aus dem horizontalen Bereich des Riemenantriebs im Uhrzeigersinn herausgefahren und damit den Speicherbereich für die Zwischenlagen 6 auf der Magazin-Rückseite verlassen haben.

## Patentansprüche

1. Vorrichtung zum Speichern und Transportieren von oberflächenempfindlichen Leiterplatten in Form eines Magazins, bestehend aus einem Grundkörper mit Auflagefläche - Stapeltisch - oder Aufstellfläche mit schwach schräggestelltem Rückenteil - Stapelwinkel - zum Auflegen der -stellen von Leiterplatten als Stapel, wobei nach Patent (EPA ) beidseits der Auflage- bzw. Stellfläche in Richtung der Stapelung langlochförmige Bügel angeordnet sind, welche Zwischenlagen für die Leiterplatten von der hängenden Ruhestellung in die liegende oder hängende Arbeitsstellung mit zwischenliegenden Leiterplatten verschieb- und umklappbar geführt aufnehmen,
dadurch gekennzeichnet, daß parallel hierzu zwei zueinander symmetrisch angebaute, synchron verlaufende Riemenantriebe (14) mit entsprechend langlochförmiger Bahn angebracht sind, an deren Riemen jeweils Greifer (15a und 15b) so vorgesehen sind, daß diese mit dem Riemen umlaufen, wobei die Greifer aus zwei einzeln ausschwenkbarern Greiferbacken (16a und 16b) bestehen, die durch stationäre Antriebe (23 und 26) betätigbar sind und in denen vorzugsweise Sensoren (29a und 29b) zum selbsttätigen Positionieren der Greifer an einer sich in beliebiger Lage befindlichen Zwischenlage (6) eingebaut sind.

2. Vorrichtung nach Anspruch 1,
dadurch gekennzeichnet, daß die langlochförmige Bahn der Riemenantriebe (14) deckungsgleich mit der Form der Magazinbügel (4) sind.

3. Vorrichtung nach Anspruch 1 oder 2,
dadurch gekennzeichnet, daß die Greiferbacken (16a und 16b) in rechtem Winkel zur Bahn der Riemenantriebe (14) weisen und sensorgesteuert weg- und zum Transport der Zwischenlagen (6) einschwenkbar sind.

4. Vorrichtung nach einem der Ansprüche 1 bis 3,
dadurch gekennzeichnet, daß die Zwischenlagen (6) vorwärts und rückwärts über die langlochförmige Bahn mittels Greifer (15a und 15b) transportierbar sind.

5. Vorrichtung nach einem der Ansprüche 1 bis 4,
dadurch gekennzeichnet, daß die Greiferbacken (16a und 16b) an einer Trägerleiste (9) angreifen, die fest mit der Zwischenlage (6) verbunden ist und die Trägerleisten (9) mit versetzten Wulsten (11) oder Abstandshaltern zum Zwichengreifen der Backen ausgeführt sind.

6. Vorrichtung nach eine der vorhergehenden Ansprüche,
dadurch gekennzeichnet, daß die Antriebe (23 und 26) zum Verschwenken der Greiferbacken (16a und 16b) eine Druckleiste (25 und 28) an ihrem Ende aufweisen zum Verschwenken an jeder beliebigen Stell.
